(19) Europäisches Patentamt
European Patent Office
Office européen des brevets

(11) **EP 2 819 301 A2**

(12) **EUROPEAN PATENT APPLICATION**

(43) Date of publication:
**31.12.2014 Bulletin 2015/01**

(51) Int Cl.:
*H02S 40/42* (2014.01)       *H02S 40/44* (2014.01)
*H02S 40/10* (2014.01)

(21) Application number: **14168802.8**

(22) Date of filing: **19.05.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **28.06.2013   US 201361840609 P
02.08.2013   US 201313957747**

(71) Applicant: **TSMC Solar Ltd.
Taichung City 428 (TW)**

(72) Inventors:
• **Cheng, Tzu-Huan
821 Kaohsiung City (TW)**
• **Chu, Li-Huan
300 Hsin Chu City (TW)**

(74) Representative: **Goddar, Heinz J.
Boehmert & Boehmert
Anwaltspartnerschaft mbB
Patentanwälte Rechtsanwälte
Pettenkoferstrasse 20-22
80336 München (DE)**

(54) **High efficiency photovoltaic system**

(57)    A photovoltaic system includes a photovoltaic module having an upper surface. A fluid deposition unit is positioned to deposit a layer of a fluid on the upper surface of the photovoltaic module. A fluid collection unit is positioned to collect fluid deposited on the upper surface of the photovoltaic module. A fluid reservoir is con- nected to receive fluid from the fluid collection unit. A pump is connected to supply fluid from the fluid reservoir to the fluid deposition unit.

FIG. 1

EP 2 819 301 A2

**Description**

**BACKGROUND**

This application claims the benefit of United States provisional Application Serial No. 61/840,609, filed June 28, 2013, which is expressly incorporated herein by reference in its entirety.

This disclosure relates generally to the field of photovoltaic systems and more particularly to methods and systems for increasing the efficiency of a photovoltaic system in terms of power production.

The market for photovoltaic electrical generating systems in residential, commercial, and public utility applications continues to grow as an alternative to fossil fuel and nuclear generation systems. Advances in technology have led to relatively small increases in the efficiency of photovoltaic systems in terms of the ratio of power output to solar irradiance. However, there are factors that lead to inefficiencies that overshadow incremental photovoltaic efficiency increases due to technology improvements.

Photovoltaic systems convert solar irradiance to electrical power. However, the solar irradiance heats the panels of the systems. The power generated by the Photovoltaic layer of a system is reduced at elevated temperature. The negative temperature coefficient of power generation from photovoltaic modules, ranging from about -0.26% to about -0.48% per degree C results in significant power loss at higher temperatures.

Another cause of inefficiency is reflectance of the solar energy off the glass upper surface of a solar panel. Although glass is transparent, a significant amount of the incident radiation, ranging between about 3% to 8%, is reflected without reaching the photovoltaic absorber layer. A further cause of inefficiency is simply dust or the like on the upper surface of the panel. The dust reduces the amount of solar power reaching the photovoltaic absorber layer and increases the temperature of the panel by absorbing radiation.

**BRIEF DESCRIPTION OF THE DRAWINGS**

Aspects of the present disclosure are best understood from the following detailed description when read with the accompanying figures. It is emphasized that, in accordance with the standard practice in the industry, various features are not drawn to scale. In fact, the dimensions of the various features can be arbitrarily increased or reduced for clarity of discussion.

Figure 1 is a partial isometric, partial block diagram of a system in accordance with various embodiments of the present disclosure.

Figure 2 is a table of module temperature and power gain in accordance with various embodiments of the present disclosure.

Figure 3 is a plot of reflectance versus wavelength for an air to glass interface.

Figure 4 is a plot of reflectance versus wavelength versus angle of incidence for an air to glass interface.

Figure 5 is a plot of reflectance versus wavelength for an air to water to glass interface.

Figure 6 is a plot of reflectance versus wavelength versus angle of incidence for an air to water to glass interface.

Figure 7 is a table of refractive indices for various materials in accordance with various embodiments of the present disclosure.

Figure 8 is a flowchart of processing in accordance with various embodiments of the present disclosure.

Figure 9 is a partial isometric, partial block diagram of a large-scale system in accordance with various embodiments of the present disclosure.

**DETAILED DESCRIPTION**

This description of the exemplary embodiments is intended to be read in connection with the accompanying drawings, which are to be considered part of the entire written description. In the description, relative terms such as "lower," "upper," "horizontal," "vertical,", "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description and do not require that the apparatus be constructed or operated in a particular orientation. Terms concerning coupling and the like, such as "connected" and "interconnected," refer to a relationship wherein devices or nodes are in direct or indirect electrical communication, unless expressly described otherwise.

It is understood that the following disclosure provides many different embodiments or examples for implementing different features of various embodiments. Specific examples of components and arrangements are described below to simplify the present disclosure. These are, of course, merely examples and are not intended to be limiting. The present disclosure may repeat reference numerals and/or letters in the various examples. This repetition is for the purpose of simplicity and clarity and does not in itself dictate a relationship between the various embodiments and/or configurations discussed.

This disclosure relates to methods and systems for increasing the efficiency of a photovoltaic system in terms of power production by cooling, reducing the reflectivity of, and removing dust and the like from, the upper surface of a photovoltaic panel.

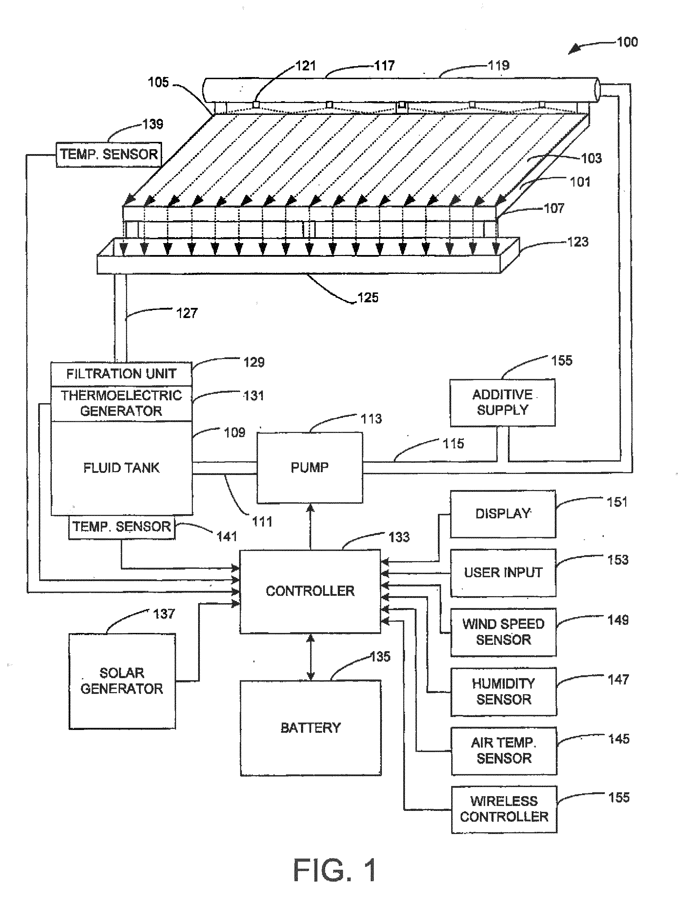

Referring now to the drawings, and first to Figure 1, a photovoltaic system according to various embodiments of the present disclosure is designated generally by the numeral 100. System 100 includes a photovoltaic panel 101. Photovoltaic panel 101 comprises an array of photovoltaic cells that can be made according to various technologies including, for example, c-Si, a-Si, CIGS, CdTe, GaAs, and the like. The photovoltaic cells are sandwiched between plates of glass held in a generally rectangular frame. Photovoltaic panel 101 thus includes a glass upper surface 103 that slopes downwardly from a top end 105 to a bottom end 107.

System 100 includes a fluid tank 109, which contains a volume of fluid (e.g. a liquid such as water), which can include various additives to be described in detail below. Fluid reservoir or tank 109 is connected by a conduit 111 to a pump 113. In various embodiments, pump 113 is electrically operated to deliver fluid from fluid tank 109 and conduit 111 to a conduit 115. Conduit 115 is connected to a fluid deposition module 117 mounted at top end 105 of photovoltaic panel 101.

Fluid deposition module 117 includes a tube 119 and a plurality of spray nozzles 121 spaced apart along tube 119 to spray fluid onto upper surface 103 of photovoltaic panel 101. As indicated by dashed lines in Figure 1, fluid sprayed by nozzles 121 flows over upper surface 103 of photovoltaic panel 101 from top end 105 to bottom end 107. Spray nozzles 121 are arranged and configured to deposit on upper surface 103 of photovoltaic panel 101 a layer of fluid of substantially uniform thickness. The thickness of the fluid layer can range from about 10 nanometers (nm) to about 3 millimeters (mm), for example.

The fluid flowing over upper surface 103 of photovoltaic panel 101 is collected in a fluid collection module 123 mounted below bottom end 107 of photovoltaic panel 101. Fluid collection module 123 includes a trough 125, or the like, and a conduit 127 connected to return fluid collected from upper surface 103 of photovoltaic panel 101 to fluid tank 109.

System 100 thus far described forms a fluid flow loop from fluid tank 111 to pump 113, to fluid deposition module 117, over upper surface 103 of photovoltaic panel 101, to fluid collection module 123, and back to fluid tank 111. As will be described in detail hereinafter, the flow of fluid over upper surface 103 of photovoltaic panel 101 increases the power efficiency of photovoltaic panel 101 by cooling photovoltaic panel 101, reducing the amount of light reflected from upper surface 103, and removing dust and the like from upper surface 103.

System 100 includes a filtration unit 129 positioned to receive fluid returning to from conduit 127 to fluid tank 109. Filtration unit 129 can include a bed of filter media (not shown) arranged to remove dust and the like from the fluid returning to fluid tank 109. Filtration unit 129 thereby maintains the clarity and transparency of the fluid.

In some embodiments, system 100 includes a thermoelectric generator 131. Thermoelectric generator 131 converts heat energy absorbed by fluid flowing over upper surface 103 of photovoltaic panel 101 to electrical energy. Thermoelectric generator 131 thus cools the fluid returning to fluid tank 109. Thermoelectric generator 131 also generates electricity that can be used, at least partially, to power pump 113 and other electrical components of system 100.

Thermoelectric generator 131 is electrically connected to a controller 133. Controller 133 is implemented in a computer programmed according to various embodiments of the present disclosure to control the operation of pump 113. Controller 133 can store power received from thermoelectric generator 131 in a battery 135.

Controller 133 is also connected to receive power from a solar generator 137. Solar generator 137 can include a relatively small array of photovoltaic cells or panels (not shown). Controller 133 can store power received from solar generator 131 in battery 135. Controller 133 supplies electric power from battery 135, thermoelectric generator 131, and/or solar generator 137 to pump 113. System 100 thus includes a self-contained power supply for flowing fluid over upper surface 103 of photovoltaic panel 101, thereby increasing the efficiency of photovoltaic panel 101 without using power generated by photovoltaic panel 101. Of course, since the power generated by photovoltaic panel 101 can be much greater than the power required to operate pump 113 and the other electric components of system 100, system 100 can use power from photovoltaic panel 101 or an external source without substantially reducing the efficiencies provided by system 100.

System 100 includes various sensors that controller 133 can use to control the operation of pump 113. More particularly, system 100 includes one or more temperature sensors 139 coupled to measure the temperature of photovoltaic panel 101. System 100 also includes one or more temperature sensors 141 coupled to measure the temperature of the fluid in fluid tank 109. Since the optimum operating temperature of photovoltaic panel 101 is about 25 degrees C, there is no need to run pump 113 when the temperature of photovoltaic panel 101 is close to a specific temperature. Also, since the cooling provided by the fluid is related to the difference between the temperatures of the fluid and photovoltaic panel 101, controller 133 can use temperature difference information to control the operation of pump 113.

In addition to the cooling attributable to the difference between the temperatures of the fluid and photovoltaic panel 101, a substantial amount of cooling can be provided by the evaporation of fluid flowing over upper surface 103 of photovoltaic panel 101. The rate of evaporation depends, in addition to the temperature of photovoltaic panel 101, the ambient air temperature, humidity, and wind speed. Accordingly, system 100 includes an air temperature sensor 145, a humidity sensor 147, and a wind speed sensor 149, each coupled to controller 133. Controller 133 can use information from sensors 145-149, in addition to information from sensors 139 and 141 to control the operation of pump 113.

System 100 also includes a display 151 and a user input device 153 coupled to controller 133, which enable an operator to monitor and interact with system 100. System 100 can also include a wireless controller 155 coupled to controller 133, which allows for remote monitor and operation of system 100.

Since the index of refraction, heat capacity, boiling point, and cleaning efficacy of the fluid can be enhanced by the presence of additives, such as various surfactant, salt, sugar, or the like, system 100 includes an additive supply 155 coupled to conduit 115. Additive supply 155 can be operated by controller 133 to introduce metered amounts of additive into the fluid.

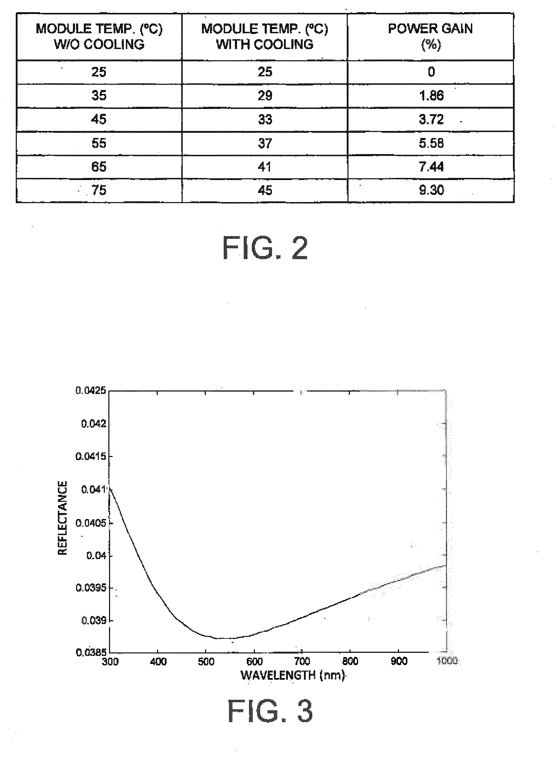

The reduction in power output of a photovoltaic panel is about -0.26% to about -0.48% per degree C above 25 degrees C. Thus, when the panel temperature is 75 degrees C, its power output is reduced by about 15% to about 20% relative to a panel at 25 degrees C. Figure 2 illustrates cases in which the fluid temperature is 25 degrees C, the panel temperature (without cooling according to embodiments of the present disclosure) ranges in ten degree C increments from 25 to 75 degree C, and the temperature coefficient of power reduction is -0.31 % per degree C. Figure 2 shows that with cooling according to embodiments of the present disclosure panel temperature is reduced by up to 30 degrees C with gain in power up to 9.3%.

The amount of power produced by photovoltaic panel 101 depends upon the amount of light that reaches the photovoltaic absorber layer of the panel. Although the glass forming upper surface 103 appears transparent, it does not transmit 100% of the light it receives to the photovoltaic layer; a certain percentage of the light falling on upper surface 103 is reflected.

The amount of light reflected as it transits from one medium to another, e.g. air to glass, depends on the respective indices of refraction of the media. When a wave moves from one medium to another, the phase velocity of the wave changes but its frequency remains constant. Refraction is described by Snell's law, which states that for a given pair of media and a wave with a single frequency, the ratio of the sines of the angle of incidence 91 and angle of refraction 92 is equivalent to the ratio of phase velocities (v1/v2 in the two media, or equivalently, to the opposite ratio of the indices of refraction (n2/n1).

The incident wave is only partially refracted and transmitted from the first medium to the second. When light moves from a medium of a given refractive index n1 into a second medium with refractive index n2, both reflection and refraction of the light may occur. An incident light ray IO strikes the interface between two media of refractive indices n1 and n2 at point O. Part of the ray is reflected as ray OR and part refracted as ray OT. The angles that the incident, reflected and refracted rays make to the normal of the interface are given as $\theta_i$, $\theta_r$ and $\theta_t$, respectively. The relationship between these angles is given by the law of reflection:

$$\theta_i = \theta_r$$

and Snell's law:

$$\sin\theta_1/\sin\theta_2 = n1/n2$$

The fraction of the incident power that is reflected is given by Fresnel's equation in which the fraction of incident power R is given by:

$$Rs = \left| (n1\cos\theta i - n2\cos\theta t)/(n1\cos\theta i + n2\cos\theta t) \right|^2$$

By inspection, it may be seen that the greater the difference between the respective indices of refraction of the media, the greater the fraction of incident power that will be reflected. The reflectance of light of various wavelengths occasioned by the transition from air (refractive index = 1) to glass (refractive index = 1.5) is illustrated in Figures 3 - 4. The average reflectance from the air-glass interface is about 3.93%, which results in an equivalent loss of reduction in power output from photovoltaic panel 101.

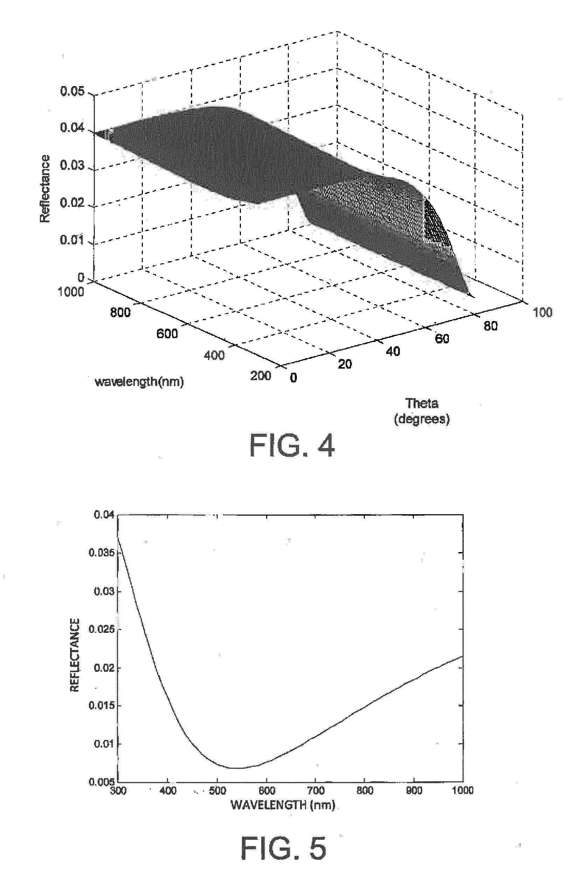

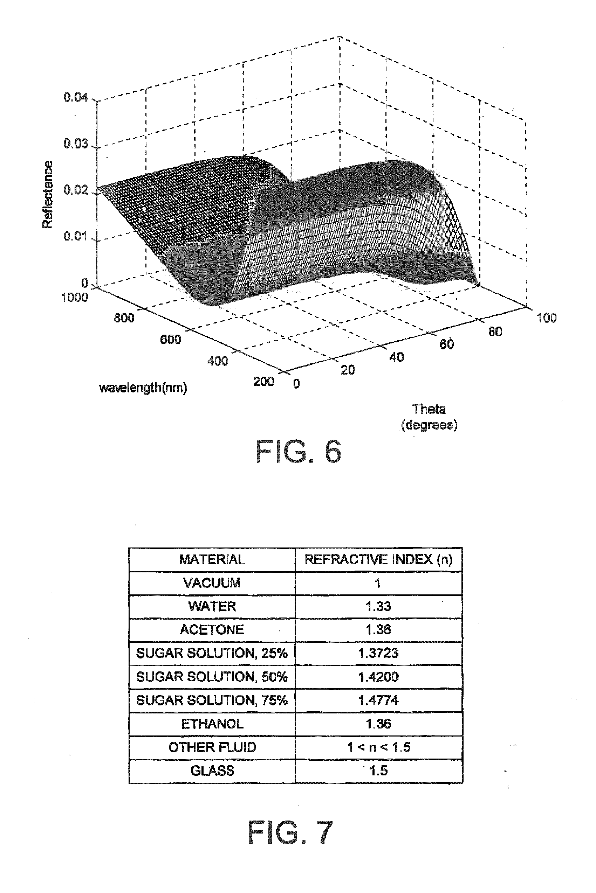

If can be demonstrated from Fresnel's equation that when light passes from a first medium having a refractive index n1 to a second medium having a refractive index n2 and then to a third medium having a refractive index n3, where n1<n2<n3, the total amount of light reflected is less than the amount reflected when the light pass directly from the first medium to the third medium. The refractive indices for various fluids are shown in Figure 7. The reflectance of light of various wavelengths occasioned by the transition from air (refractive index = 1) to water (refractive index = 1.33) to glass (refractive index = 1.5) is illustrated in Figures 5 - 6. The average reflectance from the air-water-glass interface is about 1.49%. Thus, according to embodiments in which the fluid is water, the reflectance of light entering the photovoltaic layer of panel 101 is reduced from 3.93% to 1.49%, which results in an improvement in power output efficiency from photovoltaic panel 101 of about 2.65%. Assuming a temperature of photovoltaic panel 101 of 55 degrees C, a power gain of about 9% (2.65 due to transmittance improvement, 5.58% due to cooling, and about 1% due to removal of dust and the like) is achieved according to embodiments in which the fluid is water.

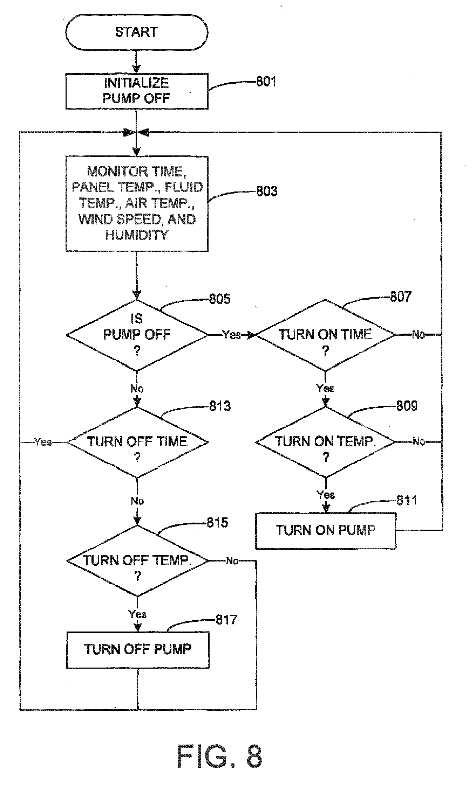

Figure 8 is a flowchart of a process of controlling pump 113 according to some embodiments of the present disclosure. Controller 133 is initialized at block 801 with the pump 113 off.

Then, as indicated at block 803, controller 133 monitors time, photovoltaic panel temperature, fluid temperature, air temperature, wind speed and humidity.

Controller 133 determines, at decision block 805, if pump 113 is turned off. If pump 113 is determined to be off, controller 133 determines, at decision block 807, the current time is a "turn-on" time. Turn-on and "turn-off' times are predetermined periods in which pump 113 is to be turned on or off. For example, in some embodiments, controller 133 can determine that pump 113 will be turned off during hours of darkness.

If controller 133 determines that the current time is not a turn-on time, then processing returns to block 803. If controller 133 determines that the current time is a turn-on time, controller 133 determines, at decision block 809, if there is currently a "turn-on" temperature condition. A turn-on temperature condition can be, for example, a photovoltaic panel 101 temperature above a threshold, or it may be based upon a difference of panel temperature and fluid temperature, or some other relationship of monitored conditions.

If controller determines that a turn-on temperature condition does not currently exist, processing returns to block 803. If a turn-on temperature condition does currently exist, controller 133 turns on pump 113, as indicated at block 811, and processing returns to block 803.

Returning to decision block 805, if pump 113 is determined not to be off (i.e., pump 113 is on), controller 133 determines, at decision block 813, if the current time is a turn-off time. If the current time is a turn-off time, controller 133 turns off pump 113, at block 817, and processing returns to block 803. If the current time is not a turn-off time, controller 133 determines, at decision block 815, if a turn-off temperature condition exists. For example, when the temperature of panel 101 cools to 25 degrees C, further cooling does not yield increases in power efficiency. Also, as shown in the table of Figure 2, there is a practical limit to how much panel 101 can be cooled under a particular set of circumstances. Accordingly, controller 133 can make the temperature condition turn-off decision on the basis of the table of Figure 2. If, at decision block 815, a turn-off temperature condition does not exist, processing returns to block 803. If a turn-off temperature condition does exist, controller 133 turns off pump 113, at block 817, and processing returns to block 803.

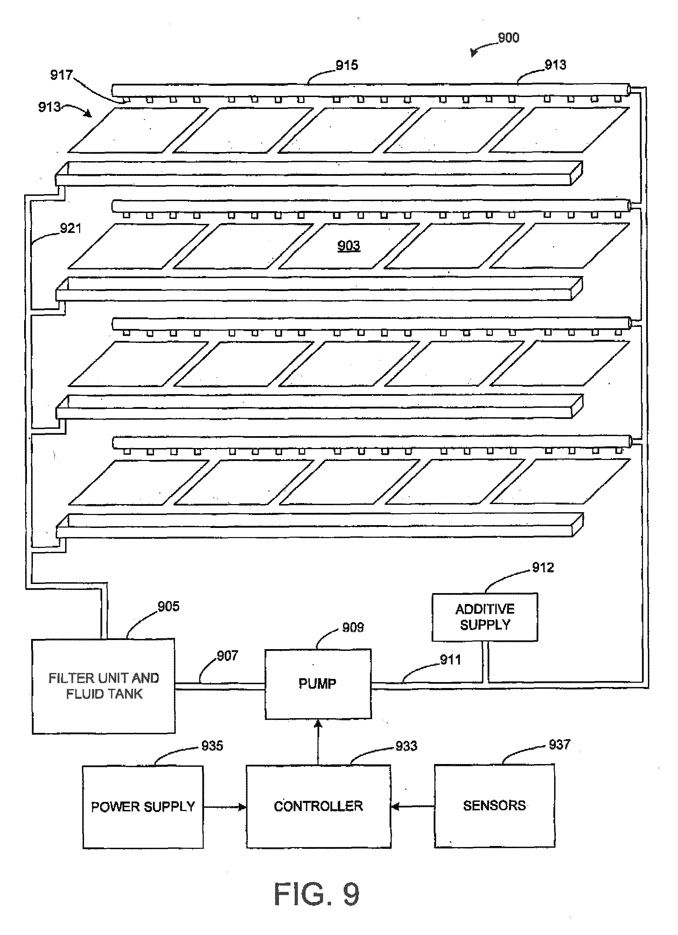

Referring now to Figure 9, a large-scale system according to various embodiments of the present disclosure is designated generally by the numeral 900. System 900 includes an array 901 of separate photovoltaic panels 903. Array 901 can comprise a plurality of substantially parallel rows of photovoltaic panels 903 covering a substantial surface area. Each panel 903 can be constructed and positioned as described with respect to panel 101 of Figure 1.

System 900 includes a filter unit and fluid tank 905, which contains a volume of liquid. Filter unit and fluid tank 905 is connected by a conduit 907 to a pump 909. Pump 909 is operated to deliver fluid from filter unit and fluid tank 905 and conduit 907 to a conduit 911. System 900 includes an additive supply 912 connected to conduit 911 to supply various additives as described with reference to Figure 1. Conduit 911 is connected to a plurality of fluid deposition modules 913 mounted to deposit fluid to flow over the surface of each photovoltaic panel 903.

Each fluid deposition module 913 includes a tube 915 and a plurality of spray nozzles 917 spaced apart along tube 915 to spray fluid onto the upper surfaces of photovoltaic panels 903. As described with reference to Figure 1, the fluid sprayed by nozzles 917 flows from top to bottom over the upper surfaces of photovoltaic panels 903. The fluid flowing over the upper surfaces of photovoltaic panels 903 is collected in a plurality of fluid collection modules 919 mounted below the bottom ends of photovoltaic panels 903. Fluid collection modules 919 are connected to a conduit 921, which returns fluid collected from the upper surfaces of photovoltaic panels 903 to filter unit and fluid tank 905. System 900 thus forms a fluid flow loop from filter unit and fluid tank 905 to pump 909, to fluid deposition modules 913, over upper surfaces of photovoltaic panels 903, to fluid collection modules 919, and back to filter unit and fluid tank 905.

System 900 includes a controller 933 programmed according to various embodiments of the present disclosure to supply power from a power supply 935 to pump 909. As described with reference to Figures 1 - 8, system 900 includes various sensors 937 that controller 933 can use to control the operation of pump 113. The respective capacities of filter unit and fluid tank 905, pump 909, additive supply 912, and power supply 935 are scaled up according to the size of system 900. System 900 provides the advantages described with reference Figures 1 - 8 to a large-scale photovoltaic power generation system.

In some embodiments, a photovoltaic system comprises: a photovoltaic module having an upper surface; a fluid deposition unit positioned to deposit a layer of a fluid on the upper surface of the photovoltaic module; a fluid collection unit positioned to collect fluid deposited on the upper surface of the photovoltaic module; a fluid reservoir connected to receive fluid from the fluid collection unit; and a pump connected to supply fluid from the fluid reservoir to the fluid deposition unit.

In some embodiments, the photovoltaic system includes a controller connected to supply power to the pump.

In some embodiments, the photovoltaic system including a filtration unit positioned to filter fluid collected by the collection unit.

In some embodiments, the photovoltaic system includes a heat extraction unit positioned to extract heat from fluid collected by the collection unit.

In some embodiments, the heat extraction unit converts heat extracted from the fluid collected by the fluid collection unit to electrical power.

In some embodiments, the refractive index of the fluid is between about 1.23 and 1.4.

In some embodiments, the fluid comprises water.

In some embodiments, the photovoltaic system includes: a plurality of photovoltaic modules, each photovoltaic module having an upper surface; a plurality of fluid deposition units positioned to deposit a layer of a fluid on the upper surfaces of the photovoltaic modules; and a plurality of fluid collection unit positioned to collect fluid deposited on the upper surfaces of the photovoltaic modules, wherein, the fluid reservoir is connected to receive fluid from the fluid collection units; and, the pump is connected to supply fluid from the fluid reservoir to the fluid deposition units.

In some embodiments, the controller supplies power to the pump based upon a temperature of the photovoltaic module.

In some embodiments, the controller supplies power to the pump based upon a temperature of the fluid in the fluid reservoir.

In some embodiments, a method of increasing the efficiency of a photovoltaic system comprises flowing a liquid over the upper surface of a photovoltaic module.

In some embodiments, the liquid has a refractive index less than a refractive index of the upper surface of the photovoltaic module.

In some embodiments, the refractive index of the liquid is between about 1.23 and 1.4. In some embodiments, the flowing includes depositing the liquid onto the upper surface; collecting the liquid deposited on the upper surface; and, returning the collected liquid for deposition on the upper surface.

In some embodiments, the method includes cooling the collected liquid prior to returning the collected liquid.

In some embodiments, a system for increasing the efficiency of a photovoltaic generator including a photovoltaic module having an upper surface comprises: a fluid deposition unit positionable to deposit a layer of a fluid on the upper surface of the photovoltaic module; a fluid collection unit positionable to collect fluid deposited on the upper surface of the photovoltaic module; a fluid reservoir connectable to receive fluid from the fluid collection unit; and a pump connectable to supply fluid from the fluid reservoir to the fluid deposition unit.

In some embodiments, the system includes a controller connectable to supply power to the pump.

In some embodiments, the system includes a filtration unit positionable to filter fluid collected by the collection unit. In some embodiments, the system includes a heat extraction unit positionable to extract heat from fluid collected by the collection unit.

In some embodiments, the fluid has a refractive index less than a refractive index of the upper surface of the photovoltaic module.

The methods and system described herein may be at least partially embodied in the form of computer-implemented processes and apparatus for practicing those processes. The disclosed methods may also be at least partially embodied in the form of tangible, non-transient machine readable storage media encoded with computer program code. The media may include, for example, RAMs, ROMs, CD-ROMs, DVD-ROMs, BD-ROMs, hard disk drives, flash memories, or any other non-transient machine-readable storage medium, wherein, when the computer program code is loaded into and executed by a computer, the computer becomes an apparatus for practicing the method. The methods may also be at least partially embodied in the form of a computer into which computer program code is loaded and/or executed, such that, the computer becomes a special purpose computer for practicing the methods. When implemented on a general-purpose processor, the computer program code segments configure the processor to create specific logic circuits. The methods may alternatively be at least partially embodied in a digital signal processor formed of application specific integrated circuits for performing the methods.

The above-described embodiments are merely possible examples of implementations, merely set forth for a clear understanding of the principles of the disclosure. Many variations and modifications can be made to the above-described embodiments of the disclosure without departing substantially from the spirit and principles of the disclosure. All such modifications and variations are intended to be included herein within the scope of this disclosure and the present disclosure and protected by the following claims.

Further, the foregoing has outlined features of several embodiments so that those skilled in the art may better understand the detailed description that follows. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions and alterations herein without departing from the spirit and scope of the present disclosure.

While preferred embodiments of the present subject matter have been described, it is to be understood that the embodiments described are illustrative only and that the appended claims shall be accorded a full range of equivalents, many variations and modifications naturally occurring to those of skill in the art from a perusal hereof.

**Claims**

1. A photovoltaic system, which comprises:

   a photovoltaic module having an upper surface;
   a fluid deposition unit positioned to deposit a layer of a fluid on the upper surface of the photovoltaic module;
   a fluid collection unit positioned to collect fluid deposited on the upper surface of the photovoltaic module;
   a fluid reservoir connected to receive fluid from the fluid collection unit; and,
   a pump connected to supply fluid from the fluid reservoir to the fluid deposition unit.

2. The photovoltaic system as claimed in claim 1, including:

   a controller connected to supply power to the pump.

3. The photovoltaic system as claimed in claim 1 or 2, including:

   a filtration unit positioned to filter fluid collected by the collection unit.

4. The photovoltaic system as claimed in any one of the preceding claims, including:

   a heat extraction unit positioned to extract heat from fluid collected by the collection unit.

5. The photovoltaic system as claimed in claim 4, wherein the heat extraction unit converts heat extracted from the fluid collected by the fluid collection unit to electrical power.

6. The photovoltaic system as claimed in any one of the preceding claims, wherein the fluid has a refractive index less than a refractive index of the upper surface of the photovoltaic module.

7. The photovoltaic system as claimed in claim 6, wherein the refractive index is between about 1.3 and 1.4.

8. The photovoltaic system as claimed in any one of the claims 2 to 7, wherein the controller supplies power to the pump based upon a temperature of the photovoltaic module.

9. The photovoltaic system as claimed in claim 8, wherein the controller supplies power to the pump based upon a temperature of the fluid in the fluid reservoir.

10. The photovoltaic system as claimed in any one of the preceding claims, including:

a plurality of photovoltaic modules, each photovoltaic module having an upper surface;
a plurality of fluid deposition units positioned to deposit a layer of a fluid on the upper surfaces of the photovoltaic modules; and,
a plurality of fluid collection unit positioned to collect fluid deposited on the upper surfaces of the photovoltaic modules, wherein,
the fluid reservoir is connected to receive fluid from the fluid collection units; and,
the pump is connected to supply fluid from the fluid reservoir to the fluid deposition units.

11. A method of increasing the efficiency of a photovoltaic system including a photovoltaic module with an upper surface, the method comprising:

flowing a liquid over the upper surface of the Photovoltaic module.

12. The method as claimed in claim 11, wherein the liquid has a refractive index less than a refractive index of the upper surface of the photovoltaic module.

13. The method as claimed in claim 12, wherein the refractive index is between about 1.23 and 1.4.

14. The method as claimed in any one of the claims 11 to 13, wherein the flowing includes:

depositing the liquid onto the upper surface;
collecting the liquid deposited on the upper surface; and,
returning the collected liquid for deposition on the upper surface.

15. The method as claimed in claim 14, including cooling the collected liquid prior to returning the collected liquid.

FIG. 1

| MODULE TEMP. (°C) W/O COOLING | MODULE TEMP. (°C) WITH COOLING | POWER GAIN (%) |
|---|---|---|
| 25 | 25 | 0 |
| 35 | 29 | 1.86 |
| 45 | 33 | 3.72 |
| 55 | 37 | 5.58 |
| 65 | 41 | 7.44 |
| 75 | 45 | 9.30 |

# FIG. 2

# FIG. 3

FIG. 4

FIG. 5

FIG. 6

| MATERIAL | REFRACTIVE INDEX (n) |
|---|---|
| VACUUM | 1 |
| WATER | 1.33 |
| ACETONE | 1.36 |
| SUGAR SOLUTION, 25% | 1.3723 |
| SUGAR SOLUTION, 50% | 1.4200 |
| SUGAR SOLUTION, 75% | 1.4774 |
| ETHANOL | 1.36 |
| OTHER FLUID | 1 < n < 1.5 |
| GLASS | 1.5 |

FIG. 7

FIG. 8

FIG. 9

**REFERENCES CITED IN THE DESCRIPTION**

**Patent documents cited in the description**

- US 61840609 B